# EUROPEAN PATENT APPLICATION

(11) **EP 4 836 640 A1**
(43) Date of publication of application: **04.11.2026**
(21) Application number: 24913563.3
(22) Date of filing: 04.12.2024
(51) Int. Cl.: H10F 71/00, H10F 77/12, H10F 10/17, H10F 10/19, H10K 85/50, H10K 30/15, H10K 30/40, H10K 30/57

(54) **POST-TREATMENT METHOD FOR PREVENTING CELL DEGRADATION OF PEROVSKITE-BASED SOLAR CELL MODULE AND PEROVSKITE-BASED SOLAR CELL MODULE TREATED THEREBY**

(30) Priority: 29.12.2023 KR 20230197047
(71) Applicant: Hanwha Solutions Corporation, Jung-gu Seoul 04541 (KR)
(72) Inventor: HAN, Sung Hoon, Seoul 04541 (KR); KIM, Myoung, Seoul 04541 (KR); KIM, Mingeon, Seoul 04541 (KR)
(74) Representative: Mooser, Sebastian Thomas
(86) International application number: PCT/KR2024/019759
(87) International publication number: WO 2025/143620

(57) **Abstract**

The present invention relates to a post-treatment method for preventing cell degradation, whereby the problem of reduced solar cell efficiency due to the thermal degradation of cells that inevitably occurs during the manufacturing process of perovskite-based solar cell modules can be prevented or minimized; and a perovskite-based solar cell post-treated by said method.

## Description

### TECHNICAL FIELD

The present invention relates to a post-treatment method for preventing cell degradation that is capable of preventing or minimizing a decrease in photovoltaic parameters (power, open-circuit voltage, short-circuit current and curve factor) of a solar cell due to ion accumulation of cationic defects and/or anionic defects in a perovskite photoactive layer caused by high temperature and/or high pressure that are inevitably applied to the front or local area of a cell during the process of manufacturing a solar cell module, and a perovskite-based solar cell module treated by this method.

### BACKGROUND ART

In order to solve the global environmental problems caused by the depletion of fossil fuels and the use thereof, research on renewable and clean alternative energy sources, such as solar energy, wind power and hydropower, is actively being conducted.

Among these, interest in solar cells that directly convert electrical energy from sunlight is increasing significantly. Here, a solar cell refers to a cell that generates current-voltage by utilizing the photovoltaic effect that generates electrons and holes by absorbing light energy from sunlight.

Currently, it is possible to manufacture n-p diode-type silicon (Si) single crystal-based solar cells with a light energy conversion efficiency of over 20%, and they are actually being used for solar power generation, and there are also solar cells using compound semiconductors such as gallium arsenide (GaAs) with an even higher conversion efficiency. However, these inorganic semiconductor-based solar cells require highly purified materials to achieve high efficiency, and thus, a lot of energy is consumed in refining the raw materials, and expensive process equipment is required in the process of using the raw materials to make a single crystal or thin film, which limits the cost of lowering the manufacturing cost of solar cells, and this has been an obstacle to large-scale utilization.

Accordingly, in order to manufacture solar cells at low cost, it is necessary to drastically reduce the cost of materials or manufacturing processes used as the core elements of solar cells, and research is being conducted on perovskite solar cells that can be manufactured by using low-cost materials and processes as an alternative to inorganic semiconductor-based solar cells.

The general structural formula of the perovskite structure is the ABX₃ structure, where an anion is located at the X site, a large cation is located at the A site, and a small cation is located at the B site.

Unlike crystalline materials, perovskite compounds, which are multi-ionic solids, contain ionic defects, and when a device composed of perovskite is exposed to an external environment (heat/light/bias/stress/moisture, etc.), these defects act as factors that impede the performance of the device, which causes problems that complicate not only the stability of perovskite solar cells but also the definition of steady-state conditions and the accurate measurement of performance parameters.

Solar cell modules inevitably require processes that apply high temperature and high pressure to the entire surface or local areas of the cell, such as tabbing and lamination, after cell manufacturing (collectively referred to as a modularization process). During the modularization process, the above-mentioned factors cause thermal degradation, which significantly reduces cell performance.

In order to solve this problem, many research resources are focused on lowering a process temperature and process pressure in the modularization process. However, the method of lowering the process temperature and pressure in the modularization process has the problem of having to verify the suitability of the modularization process again.

### DISCLOSURE

### TECHNICAL PROBLEM

The present invention aims to provide a new stabilization post-treatment method for a perovskite-based solar cell module that can perform existing solar cell module materials and processes that have already been verified, rather than a method of lowering a process temperature and process pressure that may lower the reliability of a modularization process, and a perovskite-based solar cell module manufactured by applying the post-treatment method.

### TECHNICAL SOLUTION

In order to solve the above problems, the present invention relates to a post-treatment method for preventing cell degradation of a perovskite-based solar cell module, in a process of manufacturing a solar cell module by performing a modularization process including a tabbing process, an interconnecting process, a lay-up process and a laminating process on a plurality of perovskite-based solar cells, wherein the laminating process sequentially performs an evacuating process, a melting process, a curing process and a cooling process, wherein any one or more post-treatments selected from light irradiation and bias application are performed on a solar cell module in which the curing process is completed, or any one or more post-treatments selected from light irradiation and bias application are performed after heat-treating a solar cell module in which the cooling process is completed.

In a preferred embodiment of the present invention, light irradiation and bias application may be performed together on a solar cell module in which the curing process is completed or a solar cell module in which the solar cell module in which the cooling process is completed is heat-treated.

In a preferred embodiment of the present invention, the temperatures of a solar cell module in which the curing process is completed and a solar cell module in which the solar cell module in which the cooling process is completed is heat-treated may be 50 to 100°C.

In a preferred embodiment of the present invention, the light irradiation may be performed by irradiating a solar cell module with light at 100 to 200 mW/cm² based on AM 1.5G.

In a preferred embodiment of the present invention, the bias application may be performed by applying a variable voltage (I-V sweep), a constant current or a maximum power conversion voltage (V_{MPP}) to a module.

In a preferred embodiment of the present invention, the applying a variable voltage may be performed in a range of 0.1 V to (open-circuit voltage value (VOC) + 10.0) V.

In a preferred embodiment of the present invention, the applying a constant current may be performed in a range of -50% to +50% of a short-circuit current value (I_{sc}) of a solar cell module.

In a preferred embodiment of the present invention, the plurality of perovskite-based solar cells may include a photoactive layer including a perovskite compound, and the perovskite compound may include a perovskite compound represented by Chemical Formula 1 below:

[Chemical Formula 1] Aₙ(A')₁₋ₙ BXₘ(X')₃₋ₘ

wherein in Chemical Formula 1 above, A and A' are independently formamidinium, methylammonium, cesium, rubidium, potassium, sodium, lithium, guanidinium, butylammonium, ethylammonium or phenethylammonium, B is lead, tin, germanium, cadmium, zinc or magnesium, X and X' are independently iodide, bromide, chloride, fluoride, thiocyanate, cyanate, selenocyanate, formate or acetate, n is a number satisfying 0≤n<1, and m is a number satisfying 0≤n<3.

In a preferred embodiment of the present invention, the perovskite-based solar cell module may be a module of a pin-structured perovskite solar cell, an inverse-structured perovskite solar cell, a tandem-type perovskite solar cell or a tandem-type silicon/perovskite heterojunction solar cell.

In a preferred embodiment of the present invention, a solar cell module that is post-treated by a post-treatment method for preventing cell degradation may have an increase rate of power conversion efficiency that satisfies 10.0 to 30.0% as calculated by Formula 1:
$PCE increase rate \left(%\right) = \left(A-B\right) / A \times 100 %$
wherein in Formula 1 above, A is a PCE (%) of a solar cell module that is untreated for cell degradation prevention, and B is a PCE (%) of a module that is post-treated for cell degradation prevention.

In addition, an object of the present invention is to provide a perovskite-based solar cell module that is treated by the post-treatment method for preventing cell degradation described above.

In addition, an object of the present invention is to provide a perovskite-based solar cell, including a solar cell array including the perovskite-based solar cell module.

### ADVANTAGEOUS EFFECTS

The post-treatment method for preventing cell degradation according to the present invention can be used without changing the existing solar cell module materials and processes, and can provide a perovskite-based solar cell module with extremely high efficiency by dramatically recovering thermal degradation that inevitably occurs during a high-temperature modularization process.

### DESCRIPTION OF DRAWINGS

FIG. 1 is a schematic diagram of thermal degradation of a cell that occurs during a cell laminating process during the manufacture of a solar cell module and a schematic diagram of a process by which cell performance is restored through a post-treatment process.
FIG. 2 is a schematic graph of thermal changes in an evacuating process, melting process, curing process and cooling process in a laminating process.
FIG. 3 is a photograph of the equipment that is equipped with a heat control device, a solar irradiation device and a bias application device.
FIG. 4 shows the current-voltage characteristics, that is, the photovoltaic conversion efficiency (PCE, %), open-circuit voltage (V_{oc}, V), short-circuit current density (J_{sc}, mA/cm²), and fill factor (FF, %) measurement data for the perovskite-based solar cell modules manufactured in Example 1 and the control groups in Experimental Example 1.

### MODES OF THE INVENTION

Hereinafter, the present invention will be described in more detail.

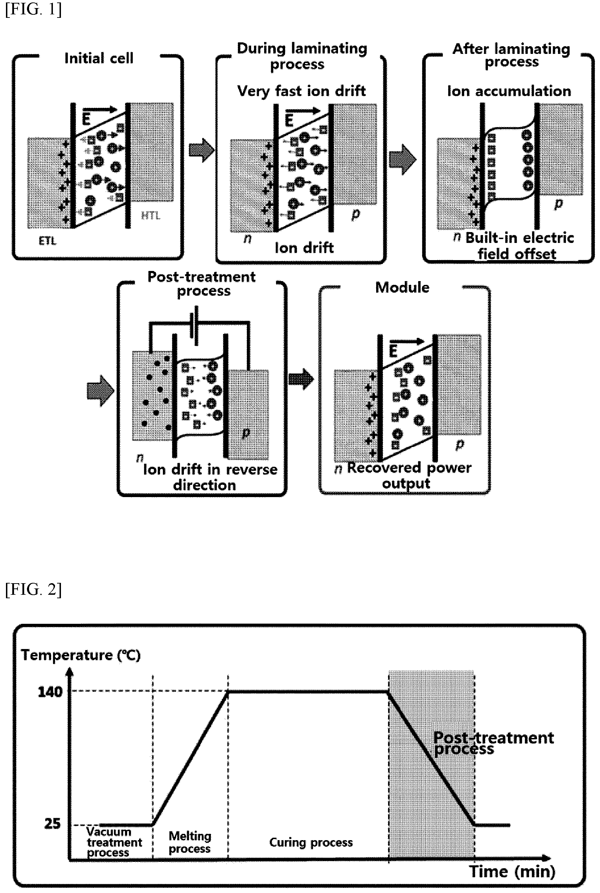

In a perovskite device, positive ion defects (A⁺, B⁺, V_{A}) and negative ion defects (X⁻) coexist inside a perovskite photoactive layer having a chemical composition of ABX₃ (refer to the circular symbols for positive ion defects and the square symbols for negative ion defects in FIG. 1).

Since perovskite devices have a built-in electric field formed from the positive electrode to the negative electrode direction, these ionic defects are gradually moved by the built-in electric field at room temperature, with positive ion defects moving toward the positive electrode and negative ion defects moving toward the negative electrode, and are accumulated at a junction interface of a perovskite layer and a charge transport layer (HTL: hole transport layer, ETL: electron transport layer), respectively.

Since the mobility of ionic defects drifting to the interface increases rapidly as the temperature of a cell increases, ionic defects drift to the interface and accumulate in a short period of time during the laminating process performed at high temperatures (see FIG. 1).

The problem is that the ionic defects accumulated at the interface form an electric field that offsets the built-in electric field, thereby canceling out the built-in electric field (built-in potential screen). This reduces all of the photovoltaic parameters (power, open-circuit voltage, short-circuit current and curvature factor) of a module, causing a significant decrease in output, and this phenomenon is the cause of thermal degradation, which typically occurs when modularizing perovskite solar cells.

Accordingly, the post-treatment method of the present invention is a treatment method for restoring the performance of a module by returning ionic defects accumulated at the interface in a direction that offsets the built-in electric field back to the original position (bulk region) as shown in FIG. 1, thereby restoring the offset built-in electric field. A cell that has undergone this post-treatment process has ionic defects uniformly distributed again within the bulk, and accordingly, the photovoltaic parameters of a thermally degraded module may be restored to the initial performance level of a cell.

In order to return the ionic defects accumulated at the interface back to their original positions (bulk regions), 1) energy higher than the activation energy of the ionic defects must be supplied to create a state of high mobility, and 2) directionality must be imparted to the movement such that the ionic defects do not move randomly but drift in a desired direction. To this end, the present invention performs the following post-treatment.

Typically, solar cell modules are manufactured by performing a modularization process including a tabbing process, an interconnecting process, a lay-up process and a laminating process on a plurality of perovskite solar cell cells.

In addition, as schematically illustrated in FIG. 2, the laminating process sequentially performs an evacuating process, a melting process, a curing process and a cooling process.

The post-treatment method for preventing cell degradation of a perovskite-based solar cell module according to the present invention supplies energy to ionic defects accumulated at the cell interface by heat-treating the module in an uncooled or cooled state after the curing process of the laminating process is performed. Then, light irradiation and/or bias application, preferably forward bias (electric field) application, is performed to impart movement directionality to the activated ionic defects.

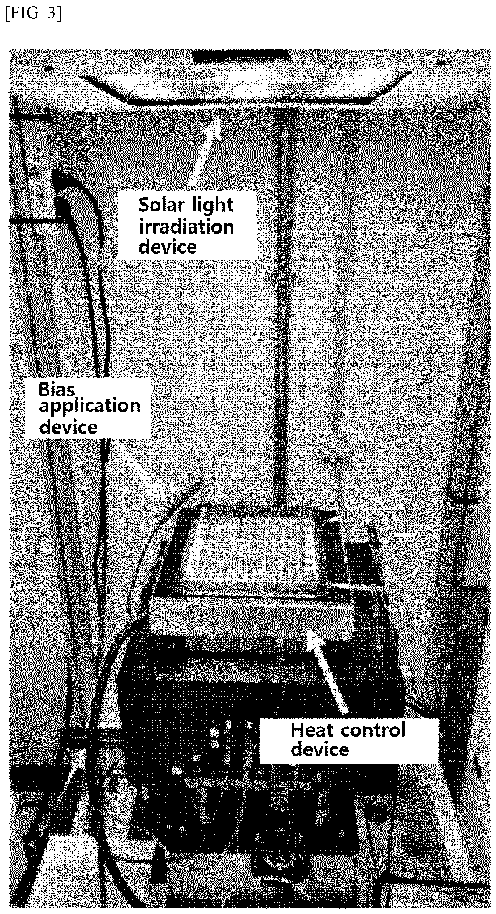

For example, in a preferred embodiment, light irradiation and bias application may be combined and performed together on a solar cell module in which the curing process is completed or a solar cell module in which the solar cell module in which the cooling process is completed is heat-treated (see FIG. 3).

The temperatures of a solar cell module, which is the target of light irradiation and bias application, a solar cell module in which the curing process is completed and a solar cell module in which the solar cell module in which the cooling process is completed is heat-treated are preferably 50 to 100°C, preferably 60 to 95°C, and more preferably 75 to 92°C. In this case, if the temperature of the solar cell module is less than 50°C, the effect of performing the post-treatment may be absent or very minimal, and if it is more than 100°C, it is uneconomical and there may be a problem of reducing the workability of the light irradiation and/or bias application treatment process.

In addition, the light irradiation may be performed by irradiating light on the solar cell module under the condition of 1 to 3 suns based on AM 1.5G, and preferably 1 to 2 suns.

In addition, the bias application is performed by applying forward bias, and may be performed by applying a variable voltage (I-V sweep), a constant current or a maximum power conversion voltage (V_{MPP}) to the module.

As a preferred embodiment, the applying a variable voltage (I-V sweep) is preferably performed in a range of 0.1 V to (open-circuit voltage value (V_{OC})+10) V, preferably 0.1 V to (V_{OC}+5.0) V, and more preferably 0.1 V to (V_{OC}+1.0) V.

In addition, it is preferable that the applying a constant current (A) is performed in a range of -50% to +50% of the short-circuit current value (I_{sc}, A), preferably -30% to +30% of the short-circuit current value (I_{sc}, A)_{,} and more preferably -10% to +10% of the short-circuit current value (I_{sc}, A).

In addition, it is desirable to perform the maximum power conversion voltage (V_{MPP}) application using the maximum power conversion voltage tracking (MPPT) method.

In addition, the solar cell module of the present invention is a module manufactured with a plurality of perovskite-based solar cell cells, wherein the plurality of perovskite-based solar cell cells include a photoactive layer including a perovskite compound, and the perovskite compound may include a perovskite compound represented by Chemical Formula 1 below.

[Chemical Formula 1] Aₙ(A')₁₋ₙ BXₘ(X')₃₋ₘ

In Chemical Formula 1 above, A and A' are independently formamidinium, methylammonium, cesium, rubidium, potassium, sodium, lithium, guanidinium, butylammonium, ethylammonium or phenethylammonium, B is lead, tin, germanium, cadmium, zinc or magnesium, X and X' are independently iodide, bromide, chloride, fluoride, thiocyanate, cyanate, selenocyanate, formate or acetate, n is a number satisfying 0≤n<1, and m is a number satisfying 0≤n<3.

In addition, the perovskite-based solar cell module may be a module of a pin-structured perovskite solar cell, an inverse-structured perovskite solar cell, a tandem-structured perovskite solar cell or a tandem-structured silicon/perovskite heterojunction solar cell.

A solar cell module that is post-treated with the post-treatment method for preventing cell degradation as described above may satisfy an increase rate (or recovery rate) in power conversion efficiency (PCE) of 10.0 to 30.0%, preferably 10.5 to 29.0%, and more preferably 11.0 to 28.0%, as calculated by Formula 1 below. [Formula 1] $PCE increase rate \left(%\right) = \left(A-B\right) / A \times 100 %$

In Formula 1, A is a PCE (%) of a solar cell module that is untreated for cell degradation prevention, and B is a PCE (%) of a module that is post-treated for cell degradation prevention.

In addition, a perovskite-based solar cell may be manufactured by manufacturing a solar cell array using a perovskite-based solar cell module that has undergone a post-treatment process using the method described above.

Hereinafter, the present invention will be described more specifically through examples, but the following examples do not limit the scope of the present invention, and should be interpreted as helping to understand the present invention.

### [Example]

### Control Group 1: Manufacture of silicon/perovskite tandem solar cell

A silicon/perovskite tandem solar cell was manufactured with a silicon lower cell and a perovskite upper cell having the following structures.

### (1) Silicon lower cell

The lower cell of the tandem solar cell uses a silicon cell with a PERC structure on the back surface of the wafer and a TOPCon structure on the front surface, but a lower cell with other polarities and structures (e.g., HIT, heterojunction with intrinsic thin layer) may also be applied.

### (2) Perovskite upper cell

The upper cell of the tandem solar cell has a p-i-n structure in which a hole transport layer is placed below the perovskite absorber layer and an electron transport layer is placed above the perovskite absorber layer, and the hole transport layer is composed of ITO/NiOₓ/Me-4PACz. Here, ITO and NiOₓ were deposited by using a sputtering process, and Me-4PACz ((4-(3,6-Dimethyl-9H-carbazol-9-yl)butyl)phosphonic acid) was coated on top of the NiOₓ using a spray process.

The perovskite absorber layer was formed by coating a solution in which precursor materials (FAI, PbI₂, CsBr, PbBr₂, MACl) were mixed, and the formed perovskite absorber layer has a composition of FAₓCs₁₋ₓPb(I_{y} Br_{1-y}Cl_{z})₃.

The electron transport layer is composed of LiF/C₆₀/SnOx. The LiF and C₆₀ layers were deposited by thermal evaporation, and the SnOₓ layer was formed by atomic layer deposition (ALD).

Finally, the upper electrode of the tandem cell is composed of ITO/Ag. ITO was deposited by using sputtering, and Ag was formed by using screen printing, thereby manufacturing a silicon/perovskite tandem solar cell.

### Control Group 2: Manufacture of silicon/perovskite tandem solar cell module

A solar cell module was manufactured by performing a tabbing process, a lay-up fixing and a laminating process on the tandem solar cell of Control Group 1 manufactured previously using the same method.

### (1) Tabbing process

Tabbing was performed by dispensing an electrical conductive adhesive (ECA) onto the upper and lower electrodes of the cell, placing a metal wire on the conductive adhesive and then heating to 130°C to join the cell and the wire. Subsequently, an interconnecting process was performed to connect the wire and the busbar.

### (2) Lay-up process

In order to modularize the tandem cell, the tandem solar cell, encapsulant and front glass, which were subjected to encapsulant, sealant and tabbing processes on the back glass, were sequentially laminated to manufacture a laminate.

In this case, the encapsulating material used polyolefin (POE), the sealing material used butyl rubber, and the front glass used low-iron tempered glass.

### (3) Laminating process

The laminated body, which had undergone the lay-up process, was compressed and subjected to a vacuum treatment process to expel all gases inside the module, and then, the module was moved to a melting chamber to perform crosslinking of the encapsulant.

Next, it was transferred to a curing chamber that could maintain a uniform temperature of 140°C such that the encapsulant was finally cross-linked by 70% or more.

Next, the module was transferred to a cooling chamber and cooled to manufacture a silicon/perovskite tandem solar cell module.

### Example 1: Performance of post-treatment to prevent cell degradation of silicon/perovskite tandem solar cell module (heat + light irradiation + bias application)

Using the same silicon lower cell and perovskite upper cell as Control Group 1, the tabbing process, layup process and laminating process were performed with the same materials, conditions and methods as Control Group 2.

However, in the laminating process of Control Group 2, the module before cooling, which had undergone the curing process, was installed in equipment equipped with a heat control device, a solar light irradiation device and a bias application device, as shown in FIG. 3, and the temperature of the cell was cooled from 100°C to 60°C at a rate of 4°C per minute, and during the cooling, 100 mW/cm² of solar radiation with AM 1.5 was irradiated and a variable voltage (I-V sweep) having a range of 0.1 V to 1.8 V was repeatedly applied until the temperature of the cell reached 60°C, thereby performing post-treatment to prevent cell degradation.

Then, the solar cell module that had undergone cell degradation prevention post-treatment was subjected to the same cooling process as Control Group 2, and a silicon/perovskite tandem solar cell module that had undergone degradation prevention post-treatment was manufactured.

The manufactured module size was a 1-inch single-cell module.

### Experimental Example 1: Measurement of solar cell module performance

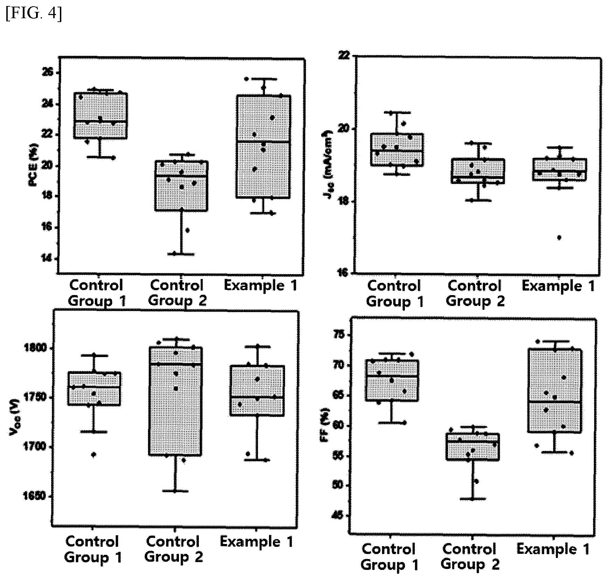

The current-voltage characteristics, that is, photovoltaic conversion efficiency (PCE, %), open-circuit voltage (V_{oc} , V), short-circuit current density (J_{sc}, mA/cm²) and fill factor (FF, %), of the tandem solar cell of Control Group 1 and the tandem solar cell modules manufactured in Example 1 and Control Group 2 were measured, and the results are shown in Table 1 and FIG. 4 below.

In addition, the increase rates of photoelectric conversion efficiency (PCE), open-circuit voltage (V_{oc}), short-circuit current density (J_{sc}) and fill factor (FF, %) in Table 1 were calculated by using the following formula. [Formula] $Increase rate \left(%\right) = \left(A-B\right) / A \times 100 %$

In the formula, A is a current-voltage characteristic measurement value of the control group, which is an untreated solar cell module to prevent cell degradation, and B is a current-voltage characteristic measurement value of the module which is post-treated to prevent cell degradation.

**[Table 1]**

| Classification | Photovoltaic Conversion Efficiency (PCE, %) | Open-Circuit Voltage (V_{oc}, V) | Short-Circuit Current Density (J_{sc}, mA/cm²) | Fill Factor (FF, %) |
|---|---|---|---|---|
| Control Group 1 | 22.89 | 1.761 | 19.43 | 68.3 |
| Control Group 2 | 19.40 | 1.786 | 18.70 | 57.5 |
| Example 1 | 21.63 | 1.752 | 18.81 | 64.3 |
| Increase Rate | +11.49 | -1.90 | +0.59 | +11.83 |

Looking at Table 1 above, it was confirmed that Example 1, which recovered the built-in electric field that had been offset by the displacement of internal ionic defects of the solar cell during the modularization process by applying light irradiation and bias, showed a significant increase in photoelectric conversion efficiency to 11.49% compared to Control Group 2. In addition, although the photoelectric conversion efficiency of Example 1 was somewhat lower than that of Control Group 1 due to a reduction in short-circuit current of the module due to light absorption and reflection of the encapsulant and front glass, it was confirmed that the performance of the solar cell, which had been reduced due to thermal degradation during the module manufacturing process, was greatly recovered.

### Example 2: Performance of post-treatment to prevent thermal degradation (heat + light irradiation + bias application)

In the same manner as in Example 1, the module before cooling, which had undergone a curing process in the laminating process of Control Group 2, was cooled from a cell temperature of 100°C to 60°C at a rate of 4°C per minute, and during the cooling process, 1 sun of solar light was irradiated with AM 1.5 and the maximum power conversion voltage (V_{MPP}) was applied until the cell temperature reached 60°C to perform post-treatment to prevent thermal degradation.

Then, the solar cell module that had undergone the post-treatment to prevent thermal degradation was subjected to the following cooling process in the same manner as Control Group 2, thereby manufacturing a tandem solar cell module.

### Experimental Example 2: Measurement of solar cell module performance

The current-voltage characteristics of the perovskite-based solar cell modules manufactured in Example 2 and the control groups were measured by using the same method as in Experimental Example 1, and the results are shown in Table 2 below.

**[Table 2]**

| Classification | Photovoltaic Conversion | Open-Circuit Voltage | Short-Circuit Current Density | Fill Factor (FF, %) |
|---|---|---|---|---|
| | Efficiency (PCE, %) | (V_{oc}, V) | (J_{sc}, mA/cm²) | |
| Control Group 2 | 18.45 | 1.774 | 18.17 | 57.2 |
| Example 2 | 22.59 | 1.758 | 17.99 | 71.4 |
| Increase Rate | +22.44 | +0.93 | -0.99 | +24.83 |

Looking at Table 2 above, it was confirmed that Example 2, which recovered the built-in electric field that had been offset by the displacement of internal ionic defects of the solar cell during the modularization process by applying light irradiation and bias, showed a significant increase in photoelectric conversion efficiency to 22.44% compared to Control Group 2.

### Example 3: Performance of post-treatment to prevent cell degradation (heat + bias application)

In the same manner as in Example 1, the module before cooling, which had undergone a curing process in the laminating process of Control Group 2, was cooled from a cell temperature of 100°C to 60°C at a rate of 4°C per minute, and during the cooling process, a current value corresponding to the short-circuit current of the cell was applied until the cell temperature reached 60°C to perform post-treatment to prevent cell degradation.

Then, the solar cell module that had undergone post-treatment to prevent cell degradation was subjected to the following cooling process in the same manner as Control Group 2, thereby manufacturing a tandem solar cell module.

### Experimental Example 3: Measurement of solar cell module performance

The current-voltage characteristics of the tandem solar cell of Control Group 1 and the tandem solar cell modules manufactured in Example 3 and Control Group 2 were measured in the same manner as in Experimental Example 1, and the results are shown in Table 3 below.

**[Table 3]**

| Classification | Photovoltaic Conversion Efficiency (PCE, %) | Open-Circuit Voltage (V_{oc}, V) | Short-Circuit Current Density (J_{sc}, mA/cm²) | Fill Factor (FF, %) |
|---|---|---|---|---|
| Control Group 1 | 21.8 | 1.760 | 19.43 | 63.7 |
| Control Group 2 | 17.5 | 1.783 | 18.75 | 51.8 |
| Example 3 | 22.15 | 1.821 | 18.64 | 65.5 |
| Increase Rate | +26.57 | +2.13 | -0.59 | +26.44 |

Looking at Table 3 above, it was confirmed that Example 3, which recovered the built-in electric field that had been offset by the displacement of internal ionic defects of the solar cell during the modularization process by applying light irradiation and bias, showed a significant increase in photoelectric conversion efficiency to 26.57% compared to Control Group 2. Furthermore, Example 3 showed a more excellent solar cell efficiency than Control Group 1.

### Example 4: Performance of post-treatment to prevent cell degradation (heat + bias application)

In the same manner as in Example 1, the module before cooling, which had undergone a curing process in the laminating process of Control Group 2, was cooled from a cell temperature of 100°C to 60°C at a rate of 4°C per minute, and during the cooling process, a variable voltage (I-V sweep) in the range of 0.1 V to 1.8 V was repeatedly applied to perform post-treatment to prevent cell degradation.

Then, the solar cell module that had undergone post-treatment to prevent cell degradation was subjected to the following cooling process in the same manner as the control group, thereby manufacturing a tandem solar cell module.

### Experimental Example 4: Measurement of Solar Cell Module Performance

The current-voltage characteristics of the tandem solar cell modules manufactured in Example 4 and Control Group 2 were measured by using the same method as in Experimental Example 1, and the results are shown in Table 4 below.

**[Table 4]**

| Classification | Photovoltaic Conversion Efficiency (PCE, %) | Open-Circuit Voltage (V_{oc}, V) | Short-Circuit Current Density (J_{sc}, mA/cm²) | Fill Factor (FF, %) |
|---|---|---|---|---|
| Control Group 2 | 18.14 | 1.803 | 18.44 | 54.5 |
| Example 4 | 22.51 | 1.806 | 17.65 | 70.6 |
| Increase Rate | +24.09 | +0.11 | -4.28 | 29.53 |

Looking at Table 4 above, it was confirmed that Example 4, which recovered the built-in electric field that had been offset by the displacement of internal ionic defects of the solar cell during the modularization process by applying light irradiation and bias, showed a significant increase in photoelectric conversion efficiency to 24.09% compared to Control Group 2.

### Example 5: Post-treatment to prevent cell degradation (heat + light irradiation)

In the same manner as in Example 1, the module before cooling, which had undergone a curing process in the laminating process of Control Group 2, was cooled from a cell temperature of 100°C to 60°C at a rate of 4°C per minute, and during the cooling process, the module was irradiated with solar light at 200 mW/cm² with AM 1.5 to prevent cell degradation.

Then, the solar cell module that had undergone post-treatment to prevent cell degradation was subjected to the following cooling process in the same manner as the control group, thereby manufacturing a tandem solar cell module.

**[Table 5]**

| Classification | Photovoltaic Conversion Efficiency (PCE, %) | Open-Circuit Voltage (V_{oc}, V) | Short-Circuit Current Density (J_{sc}, mA/cm²) | Fill Factor (FF, %) |
|---|---|---|---|---|
| Control Group | 20.81 | 1.784 | 18.40 | 63.4 |
| Example 5 | 23.30 | 1.746 | 18.12 | 73.6 |
| Increase Rate | +11.97 | -2.14 | -1.52 | +16.09 |

Looking at Table 5 above, it was confirmed that Example 5, which recovered the built-in electric field that had been offset by the displacement of internal ionic defects of the solar cell during the modularization process by irradiating light, showed a significant increase in photoelectric conversion efficiency to 11.97% compared to Control Group 2.

### Example 6 to Example 10: Performance of post-treatment to prevent cell degradation of tandem solar cell modules (heat + bias application)

In order to specify the minimum temperature of the cells in the module required for the post-treatment to prevent cell degradation, the curing process was performed in the laminating process of Control Group 2 in the same manner as in Example 1, and then, it was cooled to room temperature of 25°C. Then, the cooled module was heat-treated again to 50°C (Example 6), 60°C (Example 7), 70°C (Example 8), 80°C (Example 9) and 90°C (Example 10), and then cooled to 25°C while applying a constant current corresponding to the short-circuit current of the cell in the same manner as in Example 3 to perform the post-treatment to prevent cell degradation, thereby manufacturing perovskite-based solar cell modules, respectively.

### Experimental Example 5: Measurement of solar cell module performance

The current-voltage characteristics of the tandem solar cell of Control Group 1, the tandem solar cell modules manufactured in Examples 6 to 10 and Control Group 2 were measured in the same manner as in Experimental Example 1, and the results are shown in Table 6 below. The cell of Control Group 1 and the module of Control Group 2 were not subjected to heat treatment or thermal degradation prevention post-treatment. In addition, the experimental data values in Table 6 below represent the average values of the same experiment performed on three identical samples.

**[Table 6]**

| Experimental Temperature | Classification | Photovoltaic Conversion Efficiency (PCE, %) | Open-Circuit Voltage (V_{oc}, V) | Short-Circuit Current Density (J_{sc}, mA/cm²) | Fill Factor (FF, %) | Leakage Resistance (Ω·cm) |
|---|---|---|---|---|---|---|
| 50°C | Control Group 1 | 26.228 | 1.850 | 19.106 | 74.194 | 5.527 |
| | Control Group 2 | 22.466 | 1.798 | 18.053 | 69.213 | 10.150 |
| | Example 6 | 22.933 | 1.798 | 18.024 | 70.774 | 9.475 |
| | **Increase Rate** | **2.08%** | **-0.01%** | **-0.16%** | **2.26%** | **-6.66%** |
| 60°C | Control Group 1 | 26.32 | 1.85 | 18.61 | 76.25 | 5.09 |
| | Control Group 2 | 22.65 | 1.79 | 17.65 | 71.61 | 9.94 |
| | Example 7 | 23.25 | 1.83 | 17.54 | 72.31 | 7.56 |
| | **Increase Rate** | **2.62%** | **2.31%** | **-0.66%** | **0.97%** | **-23.96%** |
| 70°C | Control Group 1 | 26.07 | 1.86 | 18.83 | 74.51 | 4.84 |
| | Control Group 2 | 22.92 | 1.79 | 17.87 | 71.65 | 8.26 |
| | Example 8 | 23.19 | 1.84 | 17.49 | 72.15 | 6.70 |
| | **Increase Rate** | **1.16%** | **2.64%** | **-2.12%** | **0.70%** | **-18.89%** |
| 80°C | Control Group 1 | 25.34 | 1.78 | 18.80 | 75.82 | 5.21 |
| | Control Group 2 | 21.39 | 1.72 | 18.03 | 69.10 | 11.26 |
| | Example 9 | 22.96 | 1.80 | 17.51 | 72.81 | 6.97 |
| | **Increase Rate** | **7.35%** | **4.91%** | **-2.88%** | **5.37%** | **-38.08%** |
| 90°C | Control Group 1 | 25.20 | 1.85 | 18.74 | 72.64 | 5.81 |
| | Control Group 2 | 20.94 | 1.79 | 17.87 | 65.38 | 17.87 |
| | Example 10 | 22.69 | 1.83 | 17.62 | 70.24 | 7.74 |
| | **Increase Rate** | **8.39%** | **2.32%** | **-1.40%** | **7.44%** | **-56.66%** |

Looking at the photoelectric conversion efficiency increase rate in Table 6 above, it was confirmed that the post-treatment effect was present starting from a module temperature of at least 50°C. In addition, the modules of Examples 9 and 10, in which the post-treatment to prevent thermal degradation was performed at heat treatment temperatures of 80°C and 90°C, showed relatively higher photoelectric conversion efficiency increase rates compared to Examples 6 to 8, in which the post-treatment to prevent thermal degradation was performed at heat treatment temperatures of 50 to 70°C.

### Examples 11 to 14

In order to compare the effects of post-treatment to prevent thermal degradation on cell size, by using the same perovskite cell used in the module manufacture of Example 1, a 1-inch single module (Example 11), a 3-inch single module (Example 12), an M6 single module (Example 13) and an M10 single module (Example 14) were manufactured, respectively.

In addition, when manufacturing each of the modules of Examples 11 to 14 above, the module before cooling, which had undergone the curing process in the laminating process, was cooled from a cell temperature of 100°C to 60°C at a rate of 4°C per minute, and a current value corresponding to the short-circuit current of the cell was applied during the cooling process to perform post-treatment to prevent cell degradation.

### Experimental Example 6: Measurement of solar cell module performance

The current-voltage characteristics of the perovskite-based solar cell modules manufactured in Examples 11 to 14 and the perovskite cells used in the module manufacturing were measured in the same manner as in Experimental Example 1. Then, the percentage of the photoelectric conversion efficiency of the solar cell module (PCE_{module}) to the photoelectric conversion efficiency of the solar cell (PCE_{cell}) is shown in Table 7 below.

**[Table 7]**

| Classification | Module Size | PCE_{module}/ PCE_{cell} |
|---|---|---|
| Example 11 | 1-inch single module | 96% |
| Example 12 | 3-inch single module | 99% |
| Example 13 | M6 single module | 95% |
| Example 14 | M10 single module | 94% |

Looking at the measured values of the percentage of the photoelectric conversion efficiency (PCE_{module}) of the solar cell to the photoelectric conversion efficiency (PCE_{cell}) of the solar cell in Table 7 above, it was confirmed that the solar cell efficiency had a consistent recovery rate through the post-treatment process regardless of the size of the solar cell module.

Through the above examples and experimental examples, it was confirmed that the efficiency of solar cells may be dramatically recovered and restored through the post-treatment process of the present invention from a phenomenon of thermal degradation of cells due to heat during the solar cell module manufacturing process, and that it is possible to improve the reliability and mass-produce perovskite-based solar cell modules with low heat resistance.

## Claims

1. A post-treatment method for preventing cell degradation of a perovskite-based solar cell module, in a process of manufacturing a solar cell module by performing a modularization process comprising a tabbing process, an interconnecting process, a lay-up process and a laminating process on a plurality of perovskite-based solar cells, wherein the laminating process sequentially performs an evacuating process, a melting process, a curing process and a cooling process,
wherein any one or more post-treatments selected from light irradiation and bias application are performed on a solar cell module in which the curing process is completed, or any one or more post-treatments selected from light irradiation and bias application are performed after heat-treating a solar cell module in which the cooling process is completed.

2. The post-treatment method of claim 1, wherein light irradiation and bias application are performed together on a solar cell module in which the curing process is completed or a solar cell module in which the solar cell module in which the cooling process is completed is heat-treated.

3. The post-treatment method of claim 1, wherein the temperatures of a solar cell module in which the curing process is completed and a solar cell module in which the solar cell module in which the cooling process is completed is heat-treated are 50 to 100°C.

4. The post-treatment method of claim 1, wherein the light irradiation is performed by irradiating a solar cell module with light at 100 to 200 mW/cm² based on AM 1.5G.

5. The post-treatment method of claim 1, wherein the bias application is performed by applying a variable voltage (I-V sweep), a constant current or a maximum power conversion voltage (V_{MPP}) to a module.

6. The post-treatment method of claim 5, wherein the applying a variable voltage is performed in a range of 0.1 V to (open-circuit voltage value (VOC) + 10.0) V, and
wherein the applying a constant current is performed in a range of -50% to +50% of a short-circuit current value (I_{sc}) of a solar cell module.

7. The post-treatment method of claim 1, wherein the plurality of perovskite-based solar cells comprise a photoactive layer comprising a perovskite compound, and
wherein the perovskite compound comprises a perovskite compound represented by Chemical Formula 1 below:
[Chemical Formula 1] Aₙ(A')₁₋ₙ BXₘ(X')₃₋ₘ
wherein in Chemical Formula 1 above, A and A' are independently formamidinium, methylammonium, cesium, rubidium, potassium, sodium, lithium, guanidinium, butylammonium, ethylammonium or phenethylammonium, B is lead, tin, germanium, cadmium, zinc or magnesium, X and X' are independently iodide, bromide, chloride, fluoride, thiocyanate, cyanate, selenocyanate, formate or acetate, n is a number satisfying 0≤n<1, and m is a number satisfying 0≤n<3.

8. The post-treatment method of claim 7, wherein the perovskite-based solar cell module is a module of a pin-structured perovskite solar cell, an inverse-structured perovskite solar cell, a tandem-type perovskite solar cell or a tandem-type silicon/perovskite heterojunction solar cell.

9. The post-treatment method according to any one of claims 1 to 8, wherein a solar cell module that is post-treated by a post-treatment method for preventing cell degradation has an increase rate of power conversion efficiency of 10.0 to 30.0% as calculated by Formula 1: [Formula 1] $PCE increase rate \left(%\right) = \left(A-B\right) / A \times 100 %$ wherein in Formula 1 above, A is a PCE (%) of a solar cell module that is untreated for cell degradation prevention, and B is a PCE (%) of a module that is post-treated for cell degradation prevention.

10. A perovskite-based solar cell module that is treated by the post-treatment method according to any one of claims 1 to 8.

11. A perovskite-based solar cell, comprising a solar cell array comprising the perovskite-based solar cell module of claim 10.
